# EUROPÄISCHE PATENTSCHRIFT

(11) **EP 1 899 084 B1**
(45) Veröffentlichungstag und Bekanntmachung des Hinweises auf die Patenterteilung: **03.01.2018**
(21) Anmeldenummer: 06742677.5
(22) Anmeldetag: 25.04.2006
(51) Int. Cl.: B08B 9/08, H01L 21/00

(54) **VERFAHREN UND VORRICHTUNG ZUM REINIGEN ODER TROCKNEN VON TOPFARTIGEN HOHLKÖRPERN, INSBESONDERE VON TRANSPORTBEHÄLTERN FÜR HALBLEITERWAFER**
METHOD AND DEVICE FOR CLEANING OR DRYING POT-LIKE HOLLOW BODIES, PARTICULARLY TRANSPORT CONTAINERS FOR SEMICONDUCTOR WAFERS
PROCEDE ET DISPOSITIF POUR NETTOYER OU SECHER DES ELEMENTS CREUX DE TYPE CREUSETS, NOTAMMENT POUR DES CONTENANTS DE TRANSPORT DE TRANCHES DE SEMI-CONDUCTEURS

(30) Priorität: 21.06.2005 DE 102005030275
(43) Veröffentlichungstag der Anmeldung: 19.03.2008
(73) Patentinhaber: Dynamic Microsystems Semiconductor Equipment GmbH, 78315 Radolfzell (DE)
(72) Erfinder: REBSTOCK, Lutz, 78343 Gaienhofen (DE)
(74) Vertreter: m patent group
(86) Internationale Anmeldenummer: PCT/EP2006/003797
(87) Internationale Veröffentlichungsnummer: WO 2006/136224

(56) Entgegenhaltungen:
- US-A- 5 238 503
- PATENT ABSTRACTS OF JAPAN Bd. 2000, Nr. 01, 31. Januar 2000 (2000-01-31) -& JP 11 283954 A (DAINIPPON SCREEN MFG CO LTD), 15. Oktober 1999 (1999-10-15)

## Beschreibung

Die vorliegende Erfindung betrifft ein Verfahren und eine Vorrichtung zum Reinigen und/oder Trocknen von topfartigen Hohlkörpern, insbesondere von Transportbehältern für Halbleiterwafer, nach dem Oberbegriff der Ansprüche 1 bzw. 15.

Ein Verfahren und eine Vorrichtung dieser Art sind beispielsweise aus JP 11-283954 bekannt.

Die Herstellung von hochintegrierten elektronischen Schaltungen und anderen empfindlichen Halbleiterbauelementen erfolgt heutzutage in Fabriken, in denen sogenannte Halbleiterwafer eine Vielzahl von Bearbeitungsschritten durchlaufen. Ein großer Teil dieser Bearbeitungsschritte erfolgt in Reinräumen, d.h. bei Umgebungsbedingungen, die mit hohem Aufwand frei von Verunreinigungen, Fremdstoffen und dergleichen gehalten werden. Eine solch aufwendige Bearbeitung ist erforderlich, da Fremdstoffe, die mit dem Halbleitermaterial der Wafer in Berührung kommen, die Materialeigenschaften der Wafer so beeinflussen können, dass eine gesamte Produktionscharge unbrauchbar wird.

Da die Reinhaltung mit zunehmender Integrationsdichte der Halbleiterschaltungen immer wichtiger wird und der Aufwand zur Reinhaltung von großen Räumen immer höher wird, ist es bekannt, die Wafer nicht "offen" von einer Bearbeitungsstation zur nächsten zu transportieren. Stattdessen verwendet man spezielle Transportbehälter (sogenannte FOUPs, Front Opening Unified Pods). Dies sind spezielle kastenförmige Transportbehälter, in die eine Vielzahl von Wafern eingesteckt werden. Dazu besitzen die FOUPs kammartige Führungen an zwei gegenüberliegenden Längsseiten. Verschlossen werden die FOUPs üblicherweise mit einem abnehmbaren Deckel. Ohne den Deckel haben die FOUPs eine topfartige Grundform mit einer rechteckigen Grundfläche. Wenn die FOUPs mit ihrem Deckel verschlossen sind, können die eingesteckten Wafer vor der Umwelt geschützt von einem Reinraum zu einem anderen Reinraum transportiert werden.

Aufgrund der hohen Produktionsausfälle bei Verunreinigungen der Halbleiterwafer ist es erforderlich, die FOUPs von Zeit zu Zeit zu reinigen. Dies geschieht in speziellen Reinigungsanlagen, von denen eine in WO 2005/001888 A2 beschrieben ist. Diese bekannte Reinigungsanlage besitzt eine Reinigungs- bzw. Behandlungskammer, in der ein Rotor angeordnet ist, der um eine Hochachse drehbar ist. Der Rotor besitzt eine Vielzahl von Haltern, an denen die FOUPs befestigt werden. Innerhalb der Behandlungskammer sind eine Vielzahl von Sprühdüsen angeordnet, über die eine Reinigungsflüssigkeit in der Behandlungskammer versprüht wird. Während der Reinigung werden die FOUPs mit Hilfe des Rotors bewegt, so dass die Sprühdüsen jede Stelle der FOUPs erreichen können. Nach der Reinigung werden die FOUPs innerhalb der Behandlungskammer mit Hilfe eines Kondensationstrockners getrocknet.

Eine andere Vorrichtung zum Reinigen von FOUPs ist aus WO 02/17355 A2 bekannt. Auch bei dieser Vorrichtung werden die FOUPs in einer Behandlungskammer angeordnet, und es wird eine Reinigungsflüssigkeit mit Hilfe von Sprühdüsen innerhalb der Behandlungskammer versprüht.

Die JP 11-283954 offenbart ein Verfahren gemäß dem Oberbegriff des Anspruchs 1 und eine Vorrichtung gemäß dem Oberbegriff des Anspruchs 15. US 5,238,503 beschreibt eine weitere Vorrichtung zum Reinigen von Behältern für Halbleiterwafer. Sie besitzt einen bewegbaren Reinigungskopf, der von unten in den zu reinigenden Behälter einfährt und über mehrere Auslassöffnungen am oberen Ende ein Reinigungsgas ausstößt.

Die bekannten Verfahren und Vorrichtungen ermöglichen eine Reinigung der FOUPs, wie sie für heutige Bearbeitungsprozesse in Halbleiterfabriken ausreicht. Aufgrund der zunehmenden Integrationsdichte und der immer feineren Strukturen steigen jedoch die Anforderungen an die Reinheit der Produktionsprozesse und -materialien für die Halbleiterherstellung. Infolge dessen steigen auch die Anforderungen an die Reinigung der verwendeten Transportmittel.

Wenngleich FOUPs und andere für die Halbleiterherstellung verwendete Gegenstände bislang auch ohne Zwischenreinigung mehrfach verwendet wurden, steigt die Anzahl der Reinigungszyklen in den modernen Halbleiterfabriken an. Zum Teil ist es wünschenswert, eine FOUP nach jeder einzelnen Benutzung zu reinigen, um beispielsweise Kreuzkontaminationen von einer Wafercharge zur nächsten zu verhindern.

Die bekannten Verfahren und Vorrichtungen benötigen für eine vollständige Reinigung der FOUPs eine gewisse Zeit. Angesichts des erhöhten Reinigungsbedarfs ist es wünschenswert, die für die Reinigung benötigte Zeit zu reduzieren. Darüber hinaus ist es angesichts der erhöhten Reinigungszyklen wünschenswert, den Verbrauch an Reinigungsflüssigkeit möglichst gering zu halten. Andererseits muss die Reinigung sehr gründlich erfolgen, um die Reinraumanforderungen moderner Halbleiterfabriken zu erfüllen.

Vor diesem Hintergrund ist es eine Aufgabe der vorliegenden Erfindung, ein Verfahren und eine Vorrichtung der eingangs genannten Art anzugeben, um FOUPs oder ähnliche Hohlkörper mit geringem Wasserverbrauch gründlich zu reinigen.

Diese Aufgabe wird gemäß einem Aspekt der Erfindung durch ein Verfahren nach Anspruch 1 und eine Vorrichtung nach Anspruch 15 gelöst.

Das Spülmedium kann im einfachsten Fall Wasser oder eine geeignete Reinigungsflüssigkeit sein. Zum Trocknen kann als Spülmedium ein Trockengas verwendet werden, beispielsweise Luft oder Stickstoff. Das Trockengas kann erhitzt sein oder speziell entfeuchtet sein. Darüber hinaus kann grundsätzlich auch zum Reinigen der Behälter ein gasförmiges Medium verwendet werden.

Gemäß der vorliegenden Erfindung wird der Innenraum mit einem Spülkopf gespült, der in den Innenraum so weit einfährt, dass lediglich ein schmaler Zwischenraum zwischen dem Spülkopf und den Innenwänden des Hohlkörpers verbleibt. Dementsprechend gehört es zu den Merkmalen der Erfindung, dass die Außenform des Spülkopfes zumindest annähernd komplementär zu der Innenform des Innenraums ist. Hierdurch wird erreicht, dass lediglich ein geringer Zwischenraum zwischen dem Spülkopf und den Innenwänden des Hohlkörpers verbleibt. Die Reinigung oder Trocknung kann daher mit einer sehr geringen Menge an Spülmedium durchgeführt werden

Darüber hinaus wird der geringe Zwischenraum sehr schnell mit Spülmedium geflutet, was dazu führt, dass die gesamte Innenfläche des Innenraums mit Spülmedium benetzt und gespült wird. Hierdurch wird eine sehr gründliche Reinigung/Trocknung auch in versteckten Bereichen und Hinterschneidungen ermöglicht.

FOUPs besitzen üblicherweise kammartige Stege an zwei gegenüberliegenden Innenwänden. Die Stege bilden Aufnahmen, in die die einzelnen Halbleiterwafer separat eingesteckt werden. Da der Spülkopf nun eine entsprechend komplementäre Außenkontur aufweist, die zwischen die Stege eingreift, wird der Zwischenraum im Bereich der Stege minimiert. Dementsprechend ist die Strömungsgeschwindigkeit und die Strömungsrichtung des Spülmediums im Bereich der Stege noch exakter vorgegeben. Daher kann die Reinigungswirkung in dieser Ausgestaltung optimiert werden.

Ein weiterer Vorteil der Erfindung liegt darin, dass das eingesetzte Spülmedium gezielt in den Innenraum gebracht wird. Hierdurch ist es möglich, Reinigungs- bzw. Trocknungsvorrichtungen zu realisieren, die die Reinigung/Trocknung von einem oder wenigen Hohlkörpern wirtschaftlich ermöglichen, wohingegen die bekannten Vorrichtungen nur dann wirtschaftlich arbeiten, wenn die Reinigungskammern zumindest überwiegend mit FOUPs oder anderen zu reinigenden Gegenständen gefüllt sind. Die vorliegende Erfindung ermöglicht daher eine besonders wirtschaftliche Integration der Reinigungsabläufe in die Prozessabläufe einer Halbleiterfabrik. Die Zahl an FOUPs, die für eine "Blockreinigung" bevorratet werden müssen, kann reduziert werden.

Insgesamt ermöglichen das neue Verfahren und die neue Vorrichtung eine gründliche und schnelle Reinigung und/oder Trockung von FOUPs und ähnlichen Hohlkörpern bei geringem Bedarf an Spülmedium. Die genannte Aufgabe ist daher vollständig gelöst.

In einer bevorzugten Ausgestaltung wird das Spülmedium durch den Spülkopf in den Zwischenraum eingeleitet.

Alternativ hierzu wäre es grundsätzlich auch möglich, das Spülmedium neben dem Spülkopf und/oder mit einer separaten Leitung oder Düse in den Zwischenraum einzuleiten. Bei Hohlkörpern, die an ihren Boden- oder Seitenwänden Öffnungen aufweisen, könnte das Spülmedium zudem auch durch diese Öffnungen in den Zwischenraum eingeleitet werden. Die bevorzugte Ausgestaltung ist demgegenüber einfacher und kostengünstiger zu realisieren, und sie ermöglicht es, den Spülkopf sehr nah an die Innenwände des Hohlkörpers heranzufahren, so dass ein sehr kleiner Zwischenraum verbleibt. Hierdurch wird die Menge an Spülmedium weiter reduziert.

In einer weiteren bevorzugten Ausgestaltung wird das Spülmedium durch zumindest einen Spülmedienauslass in den Zwischenraum eingeleitet, der am distalen Ende des Spülkopfes angeordnet ist.

Durch diese Ausgestaltung wird im Zwischenraum eine Strömungsrichtung des Spülmediums erzwungen, die von innen nach außen verläuft. Verunreinigungen und Feuchtigkeit werden dadurch besonders wirksam aus dem Zwischenraum abgeführt.

In einer weiteren Ausgestaltung ist der zumindest eine Spülmedienauslass an einer distalen Endfläche des Spülkopfes angeordnet.

Diese Ausgestaltung ist eine optimale Variante der zuvor genannten Ausgestaltung. Sie ermöglicht eine besonders effiziente Durchspülung des Innenraums und daher eine sehr gründliche und schnelle Reinigung/Trocknung des Hohlkörpers.

In einer weiteren Ausgestaltung wird das Spülmedium durch zumindest einen Spülmedienauslass in den Zwischenraum eingeleitet, der an einer Mantelfläche des Spülkopfes angeordnet ist.

Diese Ausgestaltung besitzt den Vorteil, dass (auch) die seitlichen Innenwände des Hohlkörpers mit frischem Spülmedium gespült werden. Die Reinigung/Trocknung des Hohlkörpers lässt sich dadurch beschleunigen, und man erhält innerhalb kürzester Zeit hervorragende Ergebnisse.

In einer weiteren bevorzugten Ausgestaltung wird der Zwischenraum beim Spülen vollständig mit dem Spülmedium geflutet.

In dieser bevorzugten Ausgestaltung unterscheidet sich die Erfindung grundlegend von den bislang praktizierten Reinigungsverfahren für FOUPs und dergleichen. Während die bisherigen Verfahren die Reinigungsflüssigkeit aus einiger Entfernung versprühen, entspricht ein vollständiges Fluten des Zwischenraums der Wirkung eines Tauchbades. Sämtliche Oberflächenstellen des Innenraums werden zeitgleich mit Spülmedium benetzt. Im Gegensatz zu einem Tauchbad besitzt die bevorzugte Ausgestaltung jedoch den Vorteil, dass das Spülmedium mit einer definieren Strömungsrichtung durch den Zwischenraum gespült wird. In dem Spülmedium aufgenommene Verunreinigungen/Feutigkeitstropfen können daher nicht erneut an den Innenwänden des Hohlkörpers anhaften. Darüber hinaus ist die Menge an benötigtem Spülmedium wesentlich geringer als bei einem Tauchbad.

In einer weiteren Ausgestaltung wird das Spülmedium unter einem Druck von mehr als 1 bar in den Zwischenraum eingeleitet.

Diese Ausgestaltung verbessert die Reinigungswirkung noch weiter, da sich die Strömungsgeschwindigkeit des Spülmediums in dem Zwischenraum erhöht.

In einer weiteren bevorzugten Ausgestaltung wird an zumindest einer Außenseite des Hohlkörpers ein Spülgegenstück platziert, das mit dem Spülkopf zusammenwirkt.

Besonders bevorzugt ist es, wenn das Spülgegenstück topfartig ausgebildet ist und/oder den Hohlkörper beim Spülen zumindest teilweise umgibt.

Diese beiden Ausgestaltungen sind besonders dann von Vorteil, wenn der zu reinigende Hohlkörper im Bereich seiner Boden- und Seitenwände nicht dicht ist. Mit Hilfe dieser beiden Ausgestaltungen lässt sich nämlich die Menge an Spülmedium, die an den Öffnungen austreten kann, begrenzen. Je nachdem, an welcher Stelle eine Öffnung in den Boden- oder Seitenwänden des Hohlkörpers angeordnet ist, kann es genügen, dass das Spülgegenstück lokal auf oder an der Öffnung platziert wird. Besonders bevorzugt ist jedoch eine topfartige Ausbildung des Spülgegenstückes, weil damit auch eine Reinigung der Außenseite des Hohlkörpers möglich ist, und zwar unabhängig von dem Vorhandensein oder Nicht-Vorhandensein von Öffnungen in den Boden- oder Seitenwänden des Hohlkörpers. Die bevorzugte Ausgestaltung führt auch in diesem Fall zu einer definierten Strömungsrichtung und sie ermöglicht dadurch eine effiziente Reinigung bei geringem Verbrauch an Spülmedium.

In einer weiteren Ausgestaltung besitzt der Hohlkörper an der offenen Seite einen umlaufenden Rand, und der Spülkopf wird so in den Innenraum eingefahren, dass das Spülmedium beim Spülen an dem umlaufenden Rand austritt.

Alternativ hierzu wäre es grundsätzlich auch möglich, das Spülmedium an einer anderen Stelle aus dem Zwischenraum abzuführen. Außerdem könnte das Spülmedium auch so lange in dem Zwischenraum gehalten werden, bis der Spülkopf wieder aus dem Innenraum des Hohlkörpers herausgefahren wird. Die bevorzugte Ausgestaltung besitzt demgegenüber den Vorteil, dass eine kontinuierliche Spülung mit hoher Reinigungswirkung und geringem apparativen Aufwand realisiert werden kann.

In einer weiteren Ausgestaltung wird der Spülkopf beim Spülen in dem Innenraum bewegt. Besonders vorteilhaft wird der Spülkopf oszillierend bewegt, und zwar entweder in einer oder zwei Transversalrichtungen oder mit einer rotatorischen Oszillationsbewegung um eine Achse, die parallel oder quer zur Einfahrrichtung des Spülkopfes liegt.

Mit dieser Ausgestaltung lässt sich die Reinigungswirkung des neuen Verfahrens und der neuen Vorrichtung weiter erhöhen. Eine oszillierende Bewegung ist vorteilhaft, wenn die Grundfläche der zu reinigenden Hohlkörper nicht rotationssymmetrisch ist, wie dies beispielsweise bei FOUPs der Fall ist. Aufgrund des verbleibenden Zwischenraums zwischen den Innenwänden des Hohlkörpers und dem Spülkopf ist auch in diesen Fällen Platz, um zumindest eine geringe Oszillationsbewegung mit einer Amplitude zu ermöglichen, die kleiner als der Zwischenraum ist.

In einer weiteren Ausgestaltung besitzt der spaltförmige Zwischenraum eine Spalthöhe im Bereich zwischen 1 mm und 100 mm. Vorzugsweise liegt die Spalthöhe im Bereich zwischen etwa 10 mm und 30 mm.

Die bevorzugten Abmessungen haben sich als vorteilhaft erwiesen, da sie einerseits ein einfaches Einfahren des Spülkopfes in den Innenraum ermöglichen und andererseits die benötigte Menge an Spülmedium begrenzen. Außerdem trägt eine geringe Spalthöhe dazu bei, eine starke, gerichtete Strömung in dem Zwischenraum zu erzeugen, was eine besonders gute Reinigungs-/Trocknungswirkung zur Folge hat. Es sei an dieser Stelle allerdings darauf hingewiesen, dass die Spalthöhe nicht im gesamten Innenraum des Hohlkörpers gleich sein muss, sondern auch variieren kann, was beispielsweise von Vorteil ist, wenn der Innenraum Vorsprünge, Vertiefungen und/oder Hinterschneidungen aufweist.

In einer weiteren Ausgestaltung weist der Spülkopf eine veränderbare Außenform auf, die zum Spülen des Zwischenraums expandiert wird.

In dieser Ausgestaltung lässt sich der Spülkopf verkleinert und vergrößern. Zum Spülen wird der Spülkopf so weit vergrößert, dass der verbleibende Zwischenraum zu den Innenwänden des Hohlkörpers die gewünschte (minimale) Spalthöhe erhält. Andererseits lässt sich ein verkleinerter Spülkopf einfacher und schneller in den Innenraum des Hohlkörpers einfahren. Außerdem kann ein veränderbarer Spülkopf leicht an verschiedene Innenräume angepasst werden. Diese bevorzugte Ausgestaltung ermöglicht daher eine flexiblere und schnellere Reinigung von Hohlkörpern nach dem erfindungsgemäßen Ansatz.

Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Ausführungsbeispiele der Erfindung sind in der Zeichnung dargestellt und werden in der nachfolgenden Beschreibung näher erläutert. Es zeigen:
- Fig. 1: eine schematische Darstellung eines Ausführungsbeispiels der Erfindung in einer geschnittenen Seitenansicht,
- Fig. 2: das Ausführungsbeispiel aus Fig. 1 in einem Schnitt quer zu der Darstellung in Fig. 1, jedoch ohne Spülgegenstück,
- Fig. 3: das Ausführungsbeispiel aus Fig. 1 beim Einfahren des Spülkopfes in den Hohlkörper,
- Fig. 4: eine vereinfachte, schematische Darstellung eines Spülkopfes mit veränderbarer Außenform, und
- Fig. 5: eine schematische Darstellung einer erfindungsgemäßen Vorrichtung mit mehreren Behandlungskammern zum Reinigen und Trocknen von FOUPs.

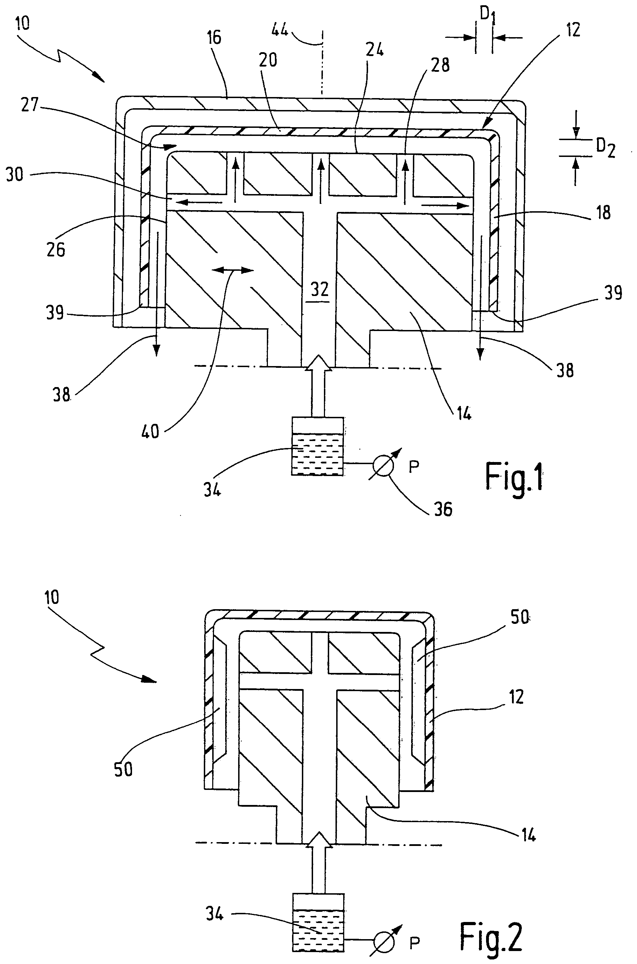

In den Figuren 1 bis 3 sind Ausführungsbeispiele der neuen Vorrichtung insgesamt mit der Bezugsziffer 10 bezeichnet. Die Vorrichtung 10 dient hier zum Reinigen von FOUPs, wie sie zum Transportieren von Halbleiterwafern in Halbleiterfabriken verwendet werden. Die Reinigung von FOUPs ist das bevorzugte Anwendungsgebiet der vorliegenden Erfindung. Sie ist hierauf jedoch nicht beschränkt und kann gleichermaßen zum Reinigen von anderen Hohlkörpern eingesetzt werden. Vorzugsweise handelt es sich dabei ebenfalls um Hohlkörper, wie sie für die Handhabung, Lagerung oder den Transport von Gegenständen benötigt werden, die in Halbleiterfabriken oder in anderen Reinraumanwendungen benötigt werden. Darüber hinaus kann die Vorrichtung 10 auch zum Trocknen von Hohlkörpern, insbesondere von FOUPs verwendet werden, indem ein geeignetes Trockengas (zum Beispiel Luft, Stickstoff u.a., vorzugsweise erwärmt und/oder entfeuchtet) als Spülmedium verwendet wird.

Ein zu reinigender FOUP ist in den Figuren 1 bis 3 mit der Bezugsziffer 12 bezeichnet. Die Vorrichtung 10 beinhaltet einen Spülkopf 14 und ein Spülgegenstück 16, wobei letzteres nur in bevorzugten Ausführungsbeispielen der Erfindung zur Anwendung kommt. In einfacheren Ausführungsbeispielen kann auf das Spülgegenstück 16 verzichtet werden, insbesondere, wenn der zu reinigende Hohlkörper, hier also der FOUP 12, lediglich an der Seite eine Öffnung aufweist, an der der Spülkopf 14 in den Hohlkörper eingefahren wird.

Der FOUP 12 besitzt Seitenwände 18 und eine Bodenwand 20, die zusammen einen Innenraum 22 begrenzen. Zum Transport von Halbleiterwafern wird ein Deckel auf den FOUP 12 aufgesetzt, der hier der Einfachheit halber nicht dargestellt ist.

Der Spülkopf 14 besitzt eine distale Endfläche 24 sowie Mantelflächen 26, die zusammen so ausgebildet sind, dass die Außenform des Spülkopfes 14 und seine äußeren Abmessungen in etwa komplementär zu der Innenform des Innenraums 22 sind. Bei eingefahrenem Spülkopf 14 verbleibt allerdings ein Zwischenraum 27 zwischen der distalen Endfläche 24 und der Bodenwand 20 sowie zwischen den Mantelflächen 26 und den Seitenwänden 18.

Der Spülkopf 14 besitzt hier sowohl an seiner distalen Endfläche 24 als auch an seinen Mantelflächen 26 Auslässe 28, 30 zum Austritt eines Spülmediums, hier zum Austritt einer Reinigungs-oder Spülflüssigkeit 34. Die Auslässe 28, 30 sind über einen Kanal 32 im Inneren des Spülkopfes 14 mit einem Reservoir verbunden, aus dem die Spülflüssigkeit 34 entnommen wird. In einem bevorzugten Ausführungsbeispiel wird die Spülflüssigkeit 34 unter einem Druck von mehr als 1 bar in den Zwischenraum 27 eingeleitet, was bei Bezugsziffer 36 schematisch angedeutet ist. Bezugsziffer 36 bezeichnet hier eine Pumpe, mit deren Hilfe sich der Druck beim Einleiten der Spülflüssigkeit 34 vorzugsweise variabel einstellen lässt.

Die Spalthöhe D₁ bzw. D₂ des Zwischenraums 27 ist hier rund um den Spülkopf 14 in etwa gleich, und sie beträgt hier etwa 20 mm. Die einschlägigen Fachleute werden jedoch erkennen, dass diese Spalthöhe kein exakter Wert sein muss, d.h. es kommt hier eher auf die Größenordnung an.

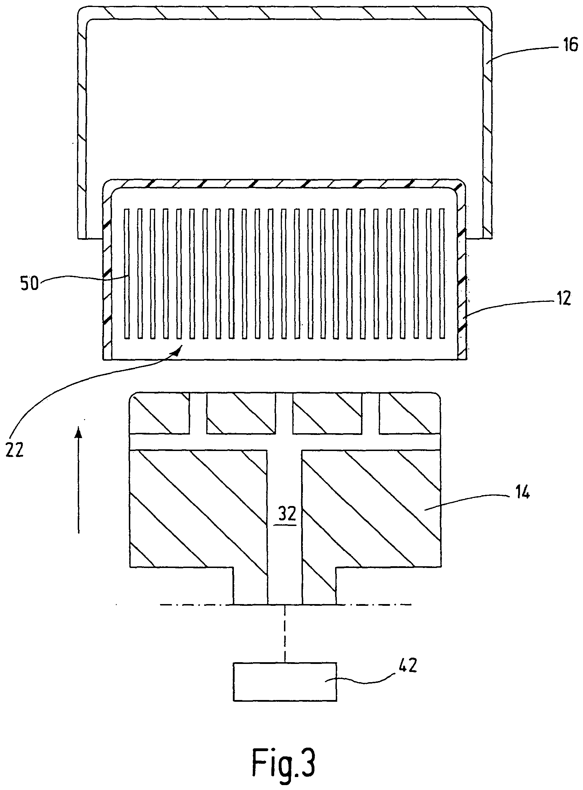

Der Verlauf der Spülflüssigkeit beim Spülen des FOUPs 12 ist mit Pfeilen dargestellt, die an den Auslässen 28, 30 eingezeichnet sind. Die Spülflüssigkeit 34 tritt an den Auslässen in der gezeigten Richtung aus und sie strömt dann nach unten (Pfeile 38), was einem bevorzugten Ausführungsbeispiel der Vorrichtung 10 entspricht, weil die Strömung der Spülflüssigkeit 34 in diesem Fall durch die Schwerkraft unterstützt wird. Der Spülkopf 14 fährt hier also von unten nach oben in den umgekehrt angeordneten FOUP 12 ein, wie dies in Fig. 3 dargestellt ist. Alternativ hierzu könnte der Spülkopf 14 grundsätzlich auch in einer anderen Raumlage in einen entsprechend ausgerichteten FOUP 12 einfahren. Die Spülflüssigkeit 34 tritt am Rand 39 des FOUP aus.

In einem bevorzugten Ausführungsbeispiel ist der Spülkopf 14 innerhalb des FOUP 12 beweglich. In einem Ausführungsbeispiel kann der Spülkopf 14 in dem Innenraum 22 eine oszillierende Bewegung ausführen, die transversal zur Einfahrrichtung des Spülkopfes 14 in den Innenraum 22 liegt (Pfeil 40 in Fig. 1). In weiteren Ausführungsbeispielen ist die oszillierende Bewegung parallel zur Einfahrrichtung des Spülkopfes 14, was vorrichtungstechnisch einfacher zu realisieren ist, da in diesem Fall der Antrieb 42 (Fig. 3) zum Einfahren des Spülkopfes 14 auch für die oszillierende Bewegung sorgen kann. In einem weiteren Ausführungsbeispiel kann die oszillierende Bewegung eine Rotation um eine Längsachse 44 beinhalten, die parallel zur Einfahrrichtung des Spülkopfes 14 liegt. Auch eine Kombination dieser Bewegungen kann vorteilhaft sein.

Darüber hinaus können andere Ausführungsbeispiele der Erfindung beinhalten, dass nicht der Spülkopf 14 mit Hilfe eines Antriebes in den Innenraum 22 des FOUP bewegt wird, sondern dass statt dessen der FOUP 12 auf den Spülkopf 14 aufgesetzt wird. "Einfahren" des Spülkopfes im Sinne der vorliegenden Erfindung beinhaltet daher beide Alternativen, wenngleich das Bewegen des Spülkopfes 14 aus heutiger Sicht bevorzugt ist.

Wie in den Figuren 2 und 3 dargestellt ist, besitzen FOUPs 12 üblicherweise Stege 50, die an gegenüberliegenden Seitenwänden 18 kammartig ausgebildet sind. Die Stege 50 ermöglichen es, die Halbleiterwafer (hier nicht dargestellt) einzeln und getrennt voneinander in den FOUP 12 einzuschieben. Der Spülkopf 14 ist mit einer Außenkontur ausgebildet, die bei eingefahrenem Spülkopf 14 zwischen die kammartigen Stege 50 eingreift (hier nicht dargestellt). In anderen Beispielen nicht gemäß der Erfindung besitzt der Spülkopf 14 keine derartige Außenkontur. Er ist statt dessen so ausgebildet, dass er auch beim vollständigen Einfahren nicht zwischen die kammartigen Stege 50 eingreift, wie dies in Fig. 2 dargestellt ist.

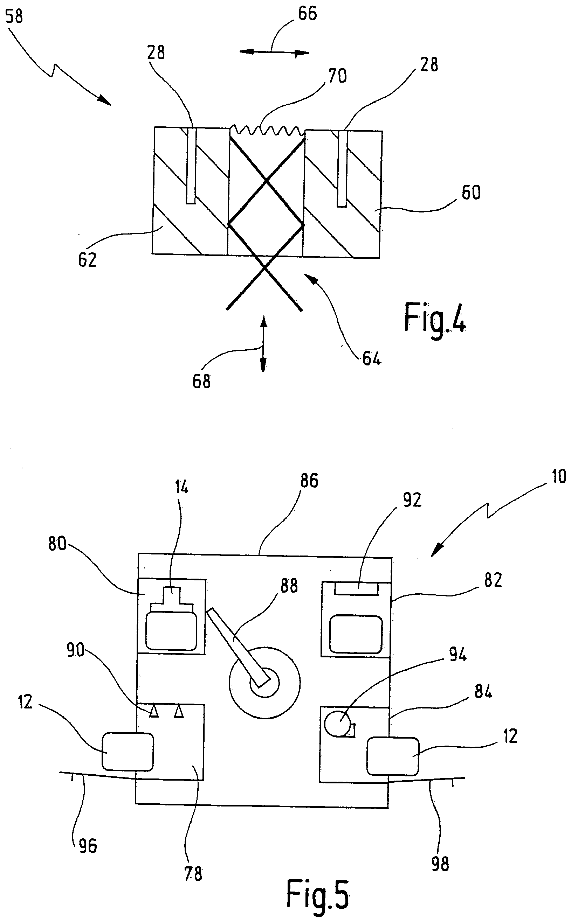

In Fig. 4 ist ein weiteres Ausführungsbeispiel eines Spülkopfes mit der Bezugsziffer 58 bezeichnet. Der Spülkopf 58 besitzt mehrere Teile 60, 62, die relativ zueinander beweglich sind. In jedem Teil 60, 62 ist hier ein Auslass 28 zum Austritt von Spülflüssigkeit angeordnet. Die beiden Teile 60, 62 sind. Ein Antriebsmechanismus 64 dient dazu, die beiden Teile 60, 62 relativ zueinander zu bewegen. Im dargestellten Ausführungsbeispiel beinhaltet der Antriebsmechanismus eine Spreize, mit deren Hilfe die beiden Teile 60, 62 in Richtung des Pfeils 66 aufeinander zu oder voneinander weg bewegt werden können. Im dargestellten Ausführungsbeispiel geschieht dies, indem auf die Enden der Spreize 64 eine Kraft in Richtung des Pfeils 68 ausgeübt wird. Zum Schutz der Spreize 64 ist eine flexible Abdeckung 70 vorgesehen.

Der in Fig. 4 dargestellte Antriebsmechanismus ist beispielhaft. In anderen Ausführungsbeispielen kann der Antriebsmechanismus als Zahnstangenantrieb und/oder als Rollenantrieb ausgebildet sein. Der Antrieb selbst kann elektromotorisch, pneumatisch, hydraulisch oder auf andere Weise ausgebildet sein. Grundsätzlich ist es auch denkbar, den Spülkopf 58 überwiegend oder vollständig aus einem flexiblen Material herzustellen, das beispielsweise mit Pressluft so weit aufgeblasen wird, dass es den Innenraum 22 eines FOUP 12 weitgehend ausfüllt und so das Volumen des Innenraums 22 auf einen schmalen, spaltförmigen Zwischenraum 27 reduziert.

In Fig. 5 ist schließlich eine bevorzugte Vorrichtung 10 in ihrer Gesamtheit dargestellt. Die Vorrichtung 10 besitzt hier mehrere Kammern 78, 80, 82, 84, die ein zu reinigender FOUP 12 der Reihe nach durchläuft. Die Kammern 78-84 sind sequentiell in einem gemeinsamen Gerätegehäuse 86 angeordnet, das so ausgebildet ist, dass der zu reinigende FOUP 12 in die erste Kammer 78 eingelegt wird und nach Durchlauf der weiteren Kammern gereinigt und getrocknet werden kann. In dem Gehäuse 86 ist ein Transportmechanismus vorgesehen, um den zu reinigenden FOUP 12 automatisch von einer Kammer zur nächsten zu transportieren. Der Transportmechanismus ist hier als Roboter 88 dargestellt, der die FOUPs auf einer gehäuseinneren Seite der Kammern 78-84 ergreift und ablegt. Die Kammer 78 ist hier beispielhaft mit Sprühdüsen 90 ausgerüstet, um die den FOUP 12 einer Vorreinigung zu unterziehen. In der Kammer 80 erfolgt das Spülen des FOUP nach dem neuen Verfahren. In der Kammer 82 wird der FOUP anschließend vorgetrocknet, und zwar vorzugsweise mit Hilfe von Infrarotstrahlung. Bei Bezugsziffer 92 ist schematisch ein Infrarotstrahler dargestellt.

In der Kammer 84 erfolgt schließlich die endgültige Trocknung, beispielsweise mit Hilfe eines Gebläses 94. Alternativ hierzu können die FOUPs 12 auch mit Hilfe eines Kondensationstrockners getrocknet werden, der in einer oder mehreren der Kammern 82, 84 vorgesehen ist.

Das Be- und Entladen der FOUPs 12 erfolgt über Außentüren 96, 98 an den Kammern 78 und 84.

## Patentansprüche

1. Verfahren zum Reinigen und/oder Trocknen von topfartigen Hohlkörpern (12), insbesondere von Transportbehältern für Halbleiterwafer, wobei die Hohlkörper (12) Wände (18, 20) besitzen, die einen Innenraum (22) mit einer definierten Innenform begrenzen, wobei der Innenraum (22) zu einer Seite hin offen ist, und wobei der Hohlkörper (12) kammartige Stege (50) in dem Innenraum (22) besitzt, mit den Schritten:
- Bereitstellen eines Spülkopfes (14; 58) mit einer Außenform, die komplementär zu der Innenform des Innenraums (22) ist,
- Einfahren des Spülkopfes (14; 58) in den Innenraum (22) von der offenen Seite her soweit, bis lediglich ein spaltförmiger Zwischenraum (27) zwischen dem Spülkopf (14) und den Wänden (18, 20) verbleibt, und
- Spülen des Zwischenraums (27) mit einem Spülmedium (34),
**dadurch gekennzeichnet, dass** der Spülkopf (14) eine Außenkontur aufweist, die zwischen die kammartigen Stege (50) eingreift.

2. Verfahren nach Anspruch 1, **dadurch gekennzeichnet, dass** das Spülmedium (34) durch den Spülkopf (14; 58) in den Zwischenraum (27) eingeleitet wird.

3. Verfahren nach Anspruch 2, **dadurch gekennzeichnet, dass** das Spülmedium (34) durch zumindest einen Spülmedienauslass (28) in den Zwischenraum (27) eingeleitet wird, der am distalen Ende des Spülkopfes (14; 58) angeordnet ist.

4. Verfahren nach Anspruch 3, **dadurch gekennzeichnet, dass** der zumindest eine Spülmedienauslass (28) an einer distalen Endfläche (24) des Spülkopfes (14; 58) angeordnet ist.

5. Verfahren nach einem der Ansprüche 2 bis 4, **dadurch gekennzeichnet, dass** das Spülmedium (34) durch zumindest einen Spülmedienauslass (30) in den Zwischenraum (27) eingeleitet wird, der an einer Mantelfläche (26) des Spülkopfes (14) angeordnet ist.

6. Verfahren nach einem der Ansprüche 1 bis 5, **dadurch gekennzeichnet, dass** der Zwischenraum (27) beim Spülen vollständig mit dem Spülmedium (34) geflutet wird.

7. Verfahren nach einem der Ansprüche 1 bis 6, **dadurch gekennzeichnet, dass** das Spülmedium (34) unter einem Druck von mehr als 1 bar in den Zwischenraum (27) eingeleitet wird.

8. Verfahren nach einem der Ansprüche 1 bis 7, **dadurch gekennzeichnet, dass** an zumindest einer Außenseite des Hohlkörpers (12) ein Spülgegezastück (16) platziert wird, das mit dem Spülkopf (14) zusammenwirkt.

9. Verfahren nach Anspruch 8, **dadurch gekennzeichnet, dass** das Spülgegenstück den Hohlkörper (12) beim Spülen zumindest teilweise umgibt.

10. Verfahren nach einem der Ansprüche 1 bis 9, **dadurch gekennzeichnet, dass** der Hohlkörper (12) an der offenen Seite einen umlaufenden Rand (39) besitzt und dass der Spülkopf (14) so in den Innenraum (22) eingefahren wird, dass das Spülmedium (34) beim Spülen an dem umlaufenden Rand (39) austritt.

11. Verfahren nach einem der Ansprüche 1 bis 10, **dadurch gekennzeichnet, dass** der Spülkopf (14) beim Spülen in dem Innenraum (22) bewegt wird.

12. Verfahren nach einem der Ansprüche 1 bis 11, **dadurch gekennzeichnet, dass** der spaltförmige Zwischenraum (27) eine Spalthöhe (D₁, D₂) im Bereich zwischen 1 mm und 100 mm besitzt.

13. Verfahren nach einem der Ansprüche 1 bis 12, **dadurch gekennzeichnet, dass** der Spülkopf (58) eine veränderbare Außenform aufweist, die zum Spülen des Zwischenraums (27) expandiert wird.

14. Verfahren nach einem der Ansprüche 1 bis 13, **dadurch gekennzeichnet, dass** als Spülmedium eine Spülflüssigkeit, insbesondere eine Reinigungsflüssigkeit, oder ein Trockengas verwendet wird.

15. Vorrichtung zum Reinigen und/oder Trocknen von topfartigen Hohlkörpern (12), insbesondere von Transportbehältern für Halbleiterwafer, wobei die Hohlkörper (12) Wände (18, 20) besitzen, die einen Innenraum (22) mit einer definierten Innenform begrenzen, wobei der Innenraum (22) zu einer Seite hin offen ist, und wobei der Hohlkörper (12) kammartige Stege (50) in dem Innenraum (22) besitzt, mit einem Spülkopf (14) mit einer Außenform, die komplementär zu der Innenform des Innenraums (22) ist, ferner mit einem Antrieb (42), um den Spülkopf (14) von der offenen Seite her so weit in den Innenraum (22) einzufahren, dass lediglich ein spaltförmigen Zwischenraum (27) zwischen dem Spülkopf (14) und den Wänden (18, 20) verbleibt, und mit zumindest einem Spülmedienauslass (28, 30), der dazu vorgesehen ist, den Zwischenraum (27) mit einem Spülmedium (34) zu spülen, **dadurch gekennzeichnet, dass** der Spülkopf (14) derart ausgebildet ist dass die Außenform eine Außenkontur aufweist, die zwischen die kammartigen Stege (50) eingreifen kann.

16. Vorrichtung nach Anspruch 15, **gekennzeichnet durch** zumindest eine erste Spülkammer (80) mit dem Spülkopf (14) sowie zumindest einer weiteren Kammer (82, 84), die in einem gemeinsamen Gerätegehäuse (86) angeordnet sind, ferner mit einem Transportmechanismus (88) zum automatischen Transportieren eines Hohlkörpers (12) innerhalb des Gerätegehäuses (86) von einer Kammer (78-84) zur nächsten.

## Claims

1. Method for cleaning and/or drying pot-like hollow bodies (12), in particular transport containers for semiconductor wafers, the hollow bodies (12) comprising walls (18, 20) that define an inner chamber (22) having a defined internal shape, the inner chamber (22) being open at one side, and the hollow body (12) comprising comb-like ribs (50) in the inner chamber (22), said method comprising the steps of:
- providing a rinsing head (14; 58) that has an external shape that is complementary to the internal shape of the inner chamber (22),
- inserting the rinsing head (14; 58) into the inner chamber (22) from the open side until only a slot-like gap (27) remains between the rinsing head (14) and the walls (18, 20), and
- rinsing the gap (27) using a rinsing medium (34),
**characterised in that** the rinsing head (14) has an external contour that engages between the comb-like ribs (50).

2. Method according to claim 1, **characterised in that** the rinsing medium (34) is introduced into the gap (27) by the rinsing head (14; 58).

3. Method according to claim 2, **characterised in that** the rinsing medium (34) is introduced into the gap (27) through at least one rinsing medium outlet (28) that is arranged on the distal end of the rinsing head (14; 58).

4. Method according to claim 3, **characterised in that** the at least one rinsing medium outlet (28) is arranged on a distal end face (24) of the rinsing head (14; 58).

5. Method according to any of claims 2 to 4, **characterised in that** the rinsing medium (34) is introduced into the gap (27) through at least one rinsing medium outlet (30) that is arranged on a lateral face (26) of the rinsing head (14).

6. Method according to any of claims 1 to 5, **characterised in that** the gap (27) is completely flooded by the rinsing medium (34) during rinsing.

7. Method according to any of claims 1 to 6, **characterised in that** the rinsing medium (34) is introduced into the gap (27) under a pressure of greater than 1 bar.

8. Method according to any of claims 1 to 7, **characterised in that** a rinsing counterpart (16) is positioned on at least one outer face of the hollow body (12), which counterpart cooperates with the rinsing head (14).

9. Method according to claim 8, **characterised in that** the rinsing counterpart surrounds the hollow body (12) at least in part during rinsing.

10. Method according to any of claims 1 to 9, **characterised in that** the hollow body (12) comprises a peripheral edge (39) on the open side, and **in that** the rinsing head (14) is inserted into the inner chamber (22) such that the rinsing medium (34) emerges at the peripheral edge (39) during rinsing.

11. Method according to any of claims 1 to 10, **characterised in that** the rinsing head (14) is moved within the inner chamber (22) during rinsing.

12. Method according to any of claims 1 to 11, **characterised in that** the slot-like gap (27) has a slot height (D₁, D₂) in the range between 1 mm and 100 mm.

13. Method according to any of claims 1 to 12, **characterised in that** the rinsing head (58) has a variable external shape that is expanded for the purpose of rinsing the gap (27).

14. Method according to any of claims 1 to 13, **characterised in that** a rinsing liquid, in particular a cleaning liquid, or a dry gas is used as the rinsing medium.

15. Apparatus for cleaning and/or drying pot-like hollow bodies (12), in particular transport containers for semiconductor wafers, the hollow bodies (12) comprising walls (18, 20) that define an inner chamber (22) having a defined internal shape, the inner chamber (22) being open at one side, and the hollow body (12) comprising comb-like ribs (50) in the inner chamber (22), said apparatus comprising a rinsing head (14) having an external shape that is complementary to the internal shape of the inner chamber (22), further comprising a drive (42) for inserting the rinsing head (14) into the inner chamber (22) from the open side to such an extent that only a slot-like gap (27) remains between the rinsing head (14) and the walls (18, 20), and comprising at least one rinsing medium outlet (28, 30) that is intended for rinsing the gap (27) using a rinsing medium (34), **characterised in that** the rinsing head (14) is designed such that the external shape has an external contour that can engage between the comb-like ribs (50).

16. Apparatus according to claim 15, **characterised by** at least one first rinsing chamber (80) comprising the rinsing head (14), and at least one further chamber (82, 84), which are arranged in a common device housing (86), further comprising a transport mechanism (88) for automatically transporting a hollow body (12) within the device housing (86) from one chamber (78-84) to the next.

## Revendications

1. Procédé pour nettoyer et/ou sécher des corps creux en forme de creusets (12), en particulier des récipients de transport pour des plaquettes semi-conductrices, dans lequel les corps creux (12) ont des parois (18, 20) qui délimitent un espace intérieur (22) ayant une forme intérieure définie, dans lequel l'espace intérieur (22) est ouvert sur un côté, et dans lequel le corps creux (12) a des nervures analogues à un peigne (50) dans l'espace intérieur (22), comportant les étapes consistant à :
- fournir une tête de rinçage (14 ; 58) ayant une forme extérieure complémentaire à la forme intérieure de l'espace intérieur (22),
- introduire la tête de rinçage (14 ; 58) dans l'espace intérieur (22) depuis le côté ouvert jusqu'à ce qu'il ne subsiste plus qu'un espace en forme d'interstice (27) entre la tête de rinçage (14) et les parois (18, 20), et
- rincer l'espace (27) avec un fluide de rinçage (34), **caractérisé en ce que** la tête de rinçage (14) présente un contour extérieur qui s'engage entre les nervures analogues à un peigne (50).

2. Procédé selon la revendication 1, **caractérisé en ce que** le fluide de rinçage (34) est introduit dans l'espace (27) à travers la tête de rinçage (14 ; 58).

3. Procédé selon la revendication 2, **caractérisé en ce que** le fluide de rinçage (34) est introduit dans l'espace (27) à travers au moins une sortie de fluide de rinçage (28) qui est agencée sur l'extrémité distale de la tête de rinçage (14 ; 58).

4. Procédé selon la revendication 3, **caractérisé en ce que** la au moins une sortie de fluide de rinçage (28) est agencée sur une face d'extrémité distale (24) de la tête de rinçage (14 ; 58).

5. Procédé selon l'une des revendications 2 à 4, **caractérisé en ce que** le fluide de rinçage (34) est introduit dans l'espace (27) à travers au moins une sortie de fluide de rinçage (30) qui est agencée sur une surface extérieure (26) de la tête de rinçage (14).

6. Procédé selon l'une des revendications 1 à 5, **caractérisé en ce que** l'espace (27) est entièrement rempli du fluide de rinçage (34).

7. Procédé selon l'une des revendications 1 à 6, **caractérisé en ce que** le fluide de rinçage (34) est introduit dans l'espace (27) sous une pression supérieure à 1 bar.

8. Procédé selon l'une des revendications 1 à 7, **caractérisé en ce que** sur au moins un côté extérieur du corps creux (12) est placée une pièce de rinçage complémentaire (16) qui coopère avec la tête de rinçage (14).

9. Procédé selon la revendication 8, **caractérisé en ce que** la pièce de rinçage complémentaire entoure au moins en partie le corps creux (12) lors d'un rinçage.

10. Procédé selon l'une des revendications 1 à 9, **caractérisé en ce que** le corps creux (12) a un bord circonférentiel (39) sur le côté ouvert et **en ce que** la tête de rinçage (14) est introduite dans l'espace intérieur (22) de sorte que le fluide de rinçage (34) sort au niveau du bord circonférentiel (39) lors d'un rinçage.

11. Procédé selon l'une des revendications 1 à 10, **caractérisé en ce que** la tête de rinçage (14) est déplacée dans l'espace intérieur (22) lors d'un rinçage.

12. Procédé selon l'une des revendications 1 à 11, **caractérisé en ce que** l'espace en forme d'interstice (27) a une hauteur d'interstice (D₁, D₂) dans la plage comprise entre 1 mm et 100 mm.

13. Procédé selon l'une des revendications 1 à 12, **caractérisé en ce que** la tête de rinçage (58) a une forme extérieure variable, qui est agrandie pour rincer l'espace (27) .

14. Procédé selon l'une des revendications 1 à 13, **caractérisé en ce qu'**un liquide de rinçage, en particulier un liquide de nettoyage ou un gaz de séchage, est utilisé comme fluide de rinçage.

15. Dispositif pour nettoyer et/ou sécher des corps creux en forme de creusets (12), en particulier des récipients de transport pour des plaquettes semi-conductrices, dans lequel les corps creux (12) ont des parois (18, 20) qui délimitent un espace intérieur (22) ayant une forme intérieure définie, dans lequel l'espace intérieur (22) est ouvert sur un côté, et dans lequel le corps creux (12) a des nervures analogues à un peigne (50) dans l'espace intérieur (22), comportant une tête de rinçage (14) ayant une forme extérieure complémentaire à la forme intérieure de l'espace intérieur (22), comportant en outre un mécanisme d'entraînement (22) afin d'introduire la tête de rinçage (14) dans l'espace intérieur (22) depuis le côté ouvert jusqu'à ce qu'il ne subsiste plus qu'un espace en forme d'interstice (27) entre la tête de rinçage (14) et les parois (18, 20), et comportant au moins une sortie de fluide de rinçage (28, 30) qui est prévue pour rincer l'espace (27) avec un fluide de rinçage (34), **caractérisé en ce que** la tête de rinçage (14) est configurée de telle sorte que la forme extérieure présente un contour extérieur qui peut s'engage entre les nervures analogues à un peigne (50).

16. Dispositif selon la revendication 15, **caractérisé par** au moins une première chambre de rinçage (80) ayant la tête de rinçage (14) ainsi qu'au moins une chambre supplémentaire (82, 84), lesquelles chambres sont agencées dans un boîtier d'appareil (86) commun, comportant en outre un mécanisme de transport (88) pour transporter automatiquement un corps creux (12) à l'intérieur du boîtier d'appareil (86) depuis une chambre (78 à 84) jusqu'à la suivante.
